Europäisches Patentamt

European Patent Office

Office européen des brevets

(11) Veröffentlichungsnummer: **0 205 185 B1**

(12) **EUROPÄISCHE PATENTSCHRIFT**

(45) Veröffentlichungstag der Patentschrift: **25.09.91**

(51) Int. Cl.⁵: **H01J 37/147**, H01J 37/28, H01J 49/06, G01R 31/28

(21) Anmeldenummer: **86108126.3**

(22) Anmeldetag: **13.06.86**

(54) **Spektrometer-Objektiv für die Elektronenstrahl-Messtechnik.**

(30) Priorität: **14.06.85 DE 3521464**

(43) Veröffentlichungstag der Anmeldung:
**17.12.86 Patentblatt  86/51**

(45) Bekanntmachung des Hinweises auf die
Patenterteilung:
**25.09.91 Patentblatt  91/39**

(84) Benannte Vertragsstaaten:
**DE FR GB NL**

(56) Entgegenhaltungen:
**EP-A- 0 105 440**

(73) Patentinhaber: **ICT Integrated Circuit Testing
Gesellschaft für Halbleiterprüftechnik mbH
Klausnerring 1a
W-8011 Heimstetten(DE)**

(72) Erfinder: **Feuerbaum, Hans-Peter, Dr.
Dipl.-Phys.
Arno-Assmann-Strasse 14
W-8000 München 83(DE)**
Erfinder: **Frosien, Jürgen, Dr. Dipl.-Ing.
An der Ottosäule 18
W-8012 Ottobrunn(DE)**

(74) Vertreter: **Tetzner, Volkmar, Dr.-Ing. Dr. jur.
Van-Gogh-Strasse 3
W-8000 München 71(DE)**

**Beschreibung**

Die Erfindung betrifft ein Spektrometer-Objektiv für die Elektronenstrahl-Meßtechnik nach dem Oberbegriff des Patentanspruchs 1.

Für quantitative Potentialmessungen an Knotenpunkten und Leiterbahnen in hochintegrierten Schaltungen werden gegenwärtig konventionelle, mit Strahlaustastsystemen und Gegenfeld-Spektrometern ausgerüstete Raster-Elektronenmikroskope eingesetzt. Mit modifizierten Raster-Elektronenmikroskopen lassen sich allerdings genügend feine Elektronensonden zur Untersuchung höchstintegrierter Schaltungen mit Strukturen im Sub-Mikrometerbereich nicht herstellen, da diese Geräte zur Vermeidung von Strahlenschäden und Aufladungen der zumeist auf isolierenden Trägersubstanzen angeordneten Bauelemente bei niedrigen Primärelektronen-Energien betrieben werden müssen. Eine deutliche Verbesserung der im wesentlichen durch den axialen Farbfehler der Objektivlinse und die Elektron-Elektron-Wechselwirkung (Boersch-Effekt) begrenzten Ortsauflösung ist nur durch einen kurzen elektronenoptischen Strahlengang mit wenigen Strahlüberkreuzungspunkten und einer Objektivlinse kurzer Brennweite erreichbar. Der Einsatz kurzbrennweitiger Objektivlinsen zur Reduktion der proportional mit der Brennweite anwachsenden axialen Farbfehler scheiterte bisher am Aufbau konventioneller Elektronenstrahl-Meßgeräte, bei denen zwischen Objektivlinse und Probe ein Sekundärelektronen-Spektrometer angeordnet ist.

Erst durch die Entwicklung von Objektivlinsen mit integriertem Sekundärelektronen-Spektrometer (Spektrometer-Objektive) konnte mit dem Arbeitsabstand die Aberration der Objektivlinse reduziert und damit der Sondendurchmesser auf der Probe verkleinert werden. Ein solches Spektrometer-Objektiv ist aus der Veröffentlichung von Kawamoto, "Electron Beam Tester with In-the-Lens-Analyzer" in den Proceedings of the Symposium on Electron-Beam-Testing, 9. bis 10. Nov. 1984, Osaka, Japan (Seite 69-72) bekannt.

Bei dieser bekannten Anordnung handelt es sich um eine magnetische Objektivlinse kurzer Brennweite mit integriertem Parallelplatten-Analysator und einer oberhalb der Objektivlinse angeordneten Elektrode zur Ablenkung der Sekundärelektronen in Richtung eines Detektors.

Obwohl der Durchmesser der Elektronensonde auf der Probe in einem mit dem bekannten Spektrometer-Objektiv ausgerüsteten Elektronenstrahl-Meßgerät gegenüber konventionellen Anordnungen deutlich verringert werden kann, bleibt die Ortsauflösung dieser Geräte begrenzt. Ursache hierfür ist die einer Fokussierung des Elektronenstrahls entgegenwirkende Coulomb-Abstoßung der Elektronen im Strahlengang zwischen Elektronenquelle und Probe.

Der Erfindung liegt die Aufgabe zugrunde, ein Spektrometer-Objektiv der eingangs genannten Art anzugeben, mit dem der elektronenoptische Strahlengang zwischen Strahlerzeuger und Probe verkürzt und damit der Einfluß des Boersch-Effektes auf den Sondendurchmesser deutlich verringert werden kann.

Diese Aufgabe wird erfindungsgemäß durch ein Spektrometer-Objektiv der eingangs genannten Art gelöst, welches die kennzeichnenden Merkmale des Patentanspruchs 1 aufweist.

Der mit der Erfindung erzielbare Vorteil besteht insbesondere darin, daß die Orts- und Potentialauflösung eines Elektronenstrahl-Meßgerätes auch bei hohen Sondenströmen deutlich gesteigert werden kann. Erfindungsgemäß erfolgt die Ablenkung der Primärelektronen innerhalb des Spektrometer-Objektivs, so daß der Raum für die in konventionellen Anordnungen verwendeten zweistufigen Ablenksysteme zwischen Kondensor- und Objektivlinse eingespart werden kann. Die hierdurch erreichbare extrem kurze Baulänge des Elektronenstrahl-Meßgerätes wirkt sich wiederum günstig auf den mit der Länge des Strahlenganges wachsenden Einfluß des lateralen Boersch-Effektes auf den Sondendurchmesser aus.

Die Patentansprüche 2 bis 7 sind auf bevorzugte Ausgestaltungen und Weiterbildungen der Erfindung gerichtet.

Das erfindungsgemäße Spektrometer-Objektiv wird nachfolgend anhand der Zeichnung erläutert. Dabei zeigen die

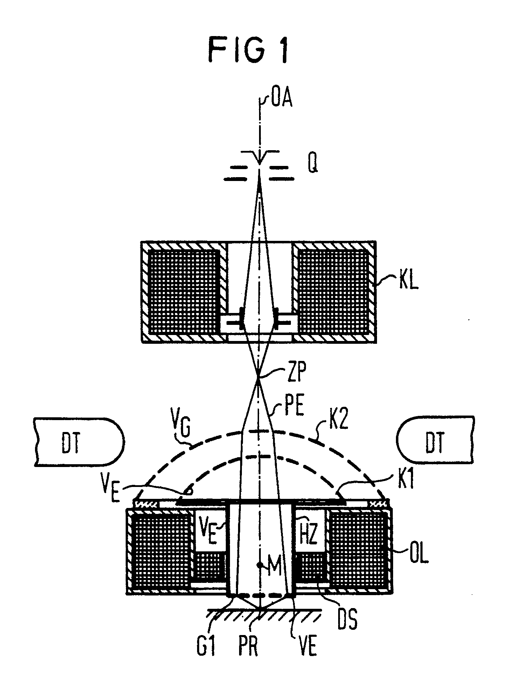

Fig. 1 bis 3    Ausführungsbeispiele erfindungsgemäßer Spektrometer-Objektive mit integriertem einstufigen Ablenksystem.

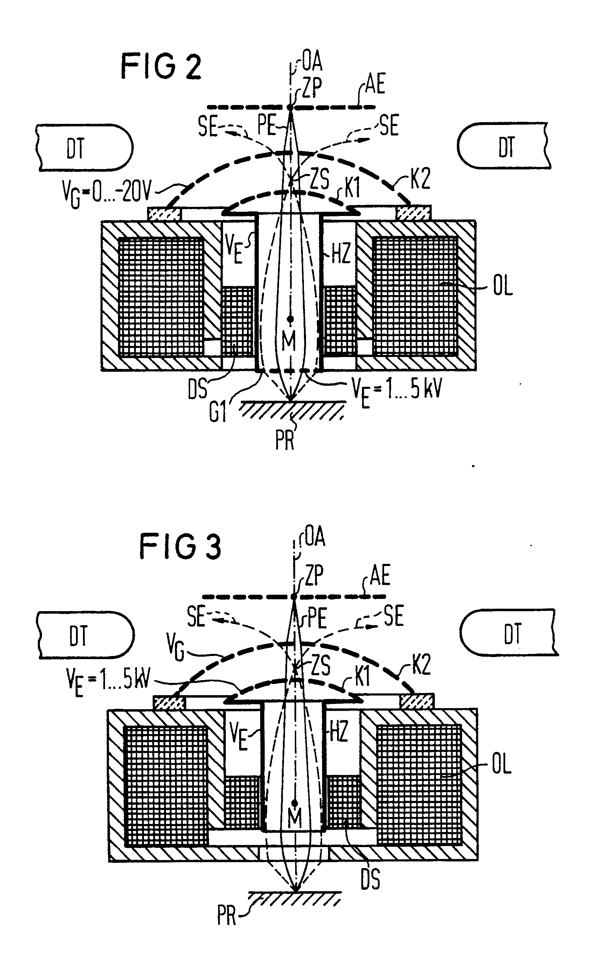

Das in den Fig.1 und 2 dargestellte Ausführungsbeispiel eines erfindungsgemäßen Spektrometer-Objektivs besteht aus einer kurzbrennweitigen, weitgehend asymmetrischen Objektivlinse OL mit integriertem elektrostatischen Gegenfeld-Spektrometer und einem einstufigen, innerhalb der Magnetlinse OL symmetrisch zur optischen Achse OA angeordneten magnetischen Ablenksystem DS. Dieses Gesamtsystem bildet eine elektronenoptische Einheit, mit der sowohl die beispielsweise in einer Hochstrom-Elektronenquelle Q erzeugten Primärelektronen PE als auch die auf einer Probe PR ausgelösten Sekundärelektronen SE in einen auf der optischen Achse OA liegenden Punkt fokussiert werden. Zur Erzeugung einer feinen Elektronensonde bildet man die Elektronenquelle Q oder das durch Kondensorlinsen KL verkleinerte Zwischenbild ZP der Quelle Q mit Hilfe des Spektrometer-Objektivs als Teil des strahlformenden Systems nochmals verkleinert auf eine in unmittelbarer Nähe der hinteren Brennebene der Objektivlinse OL angeordnete Probe PR ab. Die Verwendung von Objektivlinsen kurzer Brennweite bietet eine Reihe von Vorteilen. Infolge der bei Brennweiten zwischen 3 und 12 mm erreichbaren hohen Objektivverkleinerung kann die geforderte Systemverkleinerung durch einen kurzen Strahlengang realisiert werden. Ein kurzer Strahlengang ist aber gerade für eine Reduktion der nachteiligen Einflüsse der Elektron-Elektron- Wechselwirkung auf den Sondendurchmesser von entscheidender Bedeutung. Zusätzlich zeichnen sich Objektivlinsen kurzer Brennweite insbesondere durch geringere mit der Brennweite anwachsende axiale Farb- und Öffnungsfehler aus.

Zum Nachweis der am Meßpunkt von den hochenergetischen Primärelektronen PE infolge ihrer Wechselwirkung mit der Festkörpersubstanz ausgelösten und in einen großen Raumwinkelbereich oberhalb der Probe PR emittierten niederenergetischen Sekundärelektronen SE werden diese im elektrischen Feld einer auf hohem positiven Potential $V_E$ zwischen 1 und 5 kV liegenden Gitterelektrode G1 abgesaugt und in Richtung der optischen Achse OA beschleunigt. Die Sekundärelektronen SE durchlaufen diese ebene Gitterelektrode G1 mit hohen Energien und werden im Magnetfeld der Objektivlinse OL in einen auf der optischen Achse OA innerhalb des Spektrometer-Objektivs liegenden Punkt ZS fokussiert. Die Lage dieses Fokussierungspunktes ZS wird bestimmt von der Höhe der Spannung $V_E$ der Gitterelektrode G1 und der von der Primärelektronen-Energie abhängigen Stärke des Magnetfeldes zwischen den Polschuhen der Objektivlinse OL. Die gemeinsame Fokussierung aller Sekundärelektronen SE im Feld der Objektivlinse OL ist überhaupt nur durch deren Beschleunigung auf hohe kinetische Energien möglich, da nur dann die relative Energiebreite $\Delta$ E/$\overline{E}$ ($\overline{E}$ = mittlere kinetische Energie der Sekundärelektronen) so weit reduziert wird, daß die Bildweiten der am Meßpunkt mit unterschiedlichen Energien E emittierten Sekundärelektronen SE noch nahezu zusammenfallen. Da auch die Primärelektronen PE bei hohen Absaugspannungen $V_E$ die Objektivlinse OL mit hohen Energien durchlaufen, wird in diesem Teil des Strahlenganges auch der nachteilige Einfluß des Boersch-Effekts auf den Sondendurchmesser reduziert. Außerdem verringern sich infolge der Überlagerung des fokussierenden Magnetfeldes der Objektivlinse und des die Primärelektronen PE abbremsenden elektrischen Feldes der Absaugelektrode G1 die Öffnungs- und Farbfehler der Magnetlinse OL.

Die Abbremsung und Energieanalyse der Sekundärelektronen SE erfolgt unmittelbar oberhalb der Objektivlinse OL in einem vorzugsweise kugelsymmetrischen elektrischen Gegenfeld, das in dem Raumbereich zwischen zwei kugelsymmetrischen, auf unterschiedlichem Potential $V_E$ bzw. $V_G$ liegenden Netzelektroden K1 und K2 aufgebaut wird. Derartige Elektrodenanordnungen sind beispielsweise aus der US-A-4 464 571 bekannt.

Zur Erzeugung eines von elektrischen Feldern freien Raumes innerhalb der Objektivlinse OL ist die untere, kugelsymmetrische Netzelektrode K1 über einen konzentrisch zur optischen Achse OA angeordneten Hohlzylinder HZ leitend mit der Absaugelektrode G1 verbunden. Das Potential $V_G$ der oberen, als Gegenfeld-Gitter wirkenden Netzelektrode K2 wird durch das Probenpotential festgelegt und liegt typischerweise zwischen etwa 0 und minus 20V (volt).

Da sowohl die Primärelektronen PE als auch die von der Probe PR emittierten und im Feld der Absaugelektrode G1 beschleunigten Sekundärelektronen SE durch das integrierte Ablenksystem DS abgelenkt werden, ist darauf zu achten, daß die Sekundärelektronen-Trajektorien möglichst parallel zu den elektrischen Feldlinien des Gegenfeldes und damit senkrecht zur Oberfläche der kugelsymmetrischen Netzelektroden K1 und K2 verlaufen. Diese Bedingung ist für den Zentralstrahl der Sekundärelektronenkeule immer erfüllt, falls der gemeinsame Mittelpunkt der kugelsymmetrischen Netzelektroden K1 und K2 auf der optischen Achse OA in der Mitte M des Ablenksystems DS liegt. Da die Sekundärelektronenkeule beim Rastern der Elektronensonde um die Mitte M des Ablenksystems DS gekippt wird, ist ein orts- und winkelunabhängiger Nachweis der in Richtung der Symmetrieachse der Keule emittierten Sekundärelektronen SE mit einem oder mehreren symmetrisch zur optischen Achse OA angeordneten Detektoren DT möglich. Bei einer symmetrischen Anordnung der beispielsweise aus Abschirmgitter, Szintillator und Lichtleiter bestehenden Detektoren DT kann oberhalb der kugelsymmetrischen Netzelektroden K1 und K2 noch ein auf negativem Potential liegendes Gitter AE zur Ablenkung der in Richtung der optischen Achse OA emittierten Sekundärelektronen SE vorgesehen sein.

Das in Fig. 3 dargestellte Ausführungsbeispiel eines erfindungsgemäßen Spektrometer-Objektivs besteht aus einer kurzbrennweitigen magnetischen Objektivlinse OL mit integriertem elektrostatischen Gegenfeld-Spektrometer und einem innerhalb der Magnetlinse OL angeordneten einstufigen Ablenksystem 05. Das Absaugen und Beschleunigen der Sekundärelektronen SE erfolgt hierbei im Unterschied zu dem in Fig.l und 2 gezeigten Ausführungs-beispiel im Feld einer elektrostatischen Immersions-linse, die sich aus der kugelsymmetrischen Netzelektrode K1, dem konzentrisch zur optischen Achse DA angeordneten Hohlzylinder HZ und den auf Erdpotential liegenden Polschuhen der Objektivlinse DL zusammensetzt. Diese Kombination einer magnetischen Linse mit überlagerter elektrischer Immersionslinse zeichnet sich gegenüber Anordnungen mit nur einer Magnetlinse durch günstigere Farbfehlerwerte aus.

## Bezugszeichenliste

| | |
|---|---|
| AE | Ablenkelektrode |
| DS | Ablenksystem |
| DT | Detektor |
| G1 | Absaugelektrode |
| HZ | Hohlzylinder |
| K1/K2 | kugelsym. Netzelektroden |
| M | Mittelpunkt des Ablenksystems |
| OA | optische Achse |
| OL | Objektivlinse |
| PE | Primärelektronen (-Strahl) |
| PR | Probe |
| SE | Sekundärelektronen |
| $V_E$ | Spannung an G1, HZ und K1 |
| $V_G$ | "          an K2 |
| ZP | Zwischenbild der Primärelektronen |
| ZS | "          "  Sekundärelektronen |

**Patentansprüche**

1. Spektrometer-Objektiv für quantitative Potentialmessungen in der Elektronenstrahl-Meßtechnik, bei dem eine magnetische Objektivlinse (OL) zur Fokussierung eines Primärelektronenstrahles (PE) auf eine Probe (PR) und ein elektrostatisches Gegenfeld-Spektrometer, das eine Elektrodenanordnung (G1) zum Absaugen der auf der Probe (PR) vom Primärelektronenstrahl (PE) ausgelösten Sekundärelektronen (SE) und eine Elektrodenanordnung (K1, K2) zur Erzeugung eines die Sekundärelektronen (SE) abbremsenden elektrischen Gegenfeldes aufweist, eine elektronenoptische Einheit bilden, und dem eine Detektoranordnung (DT) zum Nachweis der Sekundärelektronen (SE) zugeordnet ist,
   dadurch **gekennzeichnet,**
   daß innerhalb einer magnetischen Objektivlinse (OL) kurzer Brennweite ein Ablenksystem (DS) vorgesehen ist, das symmetrisch zur optischen Achse (OA) zwischen der Elektrodenanordnung (G1) zum Absaugen der auf der Probe (PR) ausgelösten Sekundärelektronen (SE) und der Elektrodenanordnung (K1, K2) zur Erzeugung des die Sekundärelektronen (SE) abbremsenden elektrischen Gegenfeldes angeordnet ist.

2. Spektrometer-Objektiv nach Anspruch 1, **gekennzeichnet** durch ein einstufiges Ablenksystem (DS).

3. Spektrometer-Objektiv nach Anspruch 1 oder 2, dadurch **gekennzeichnet,**
   - daß die Elektrodenanordnung zur Erzeugung eines elektrischen Gegenfeldes zwei unmittelbar oberhalb der Objektivlinse (OL) angeordnete kugelsymmetrische Elektroden (K1, K2) aufweist, deren Potentiale ($V_E$, $V_G$) so gewählt sind,

- daß sich im Raum zwischen diesen Elektroden ein kugelsymmetrisches Gegenfeld aufbaut,
- daß die Mittelpunkte dieser kugelsymmetrischen Elektroden (K1, K2) in einem auf der optischen Achse (OA) innerhalb der Objektivlinse (OL) liegenden Punkt zusammenfallen,
- daß dieser Punkt in einem von elektrischen Feldern freien Raumbereich im Mittelpunkt (M) des Ablenksystems (DS) liegt, und
- daß die auf der Probe (PR) ausgelösten Sekundärelektronen (SE) im Feld der Objektivlinse (OL) in einen auf der optischen Achse (OA) innerhalb der Objektivlinse (OL) liegenden Punkt (ZS) fokussiert werden.

4. Spektrometer-Objektiv nach einem der Ansprüche 1 bis 3, dadurch **gekennzeichnet,** daß zur Erzeugung eines von elektrischen Feldern freien Raumes innerhalb der Objektivlinse (OL) ein konzentrisch zur optischen Achse (OA) angeordneter Hohlzylinder (HZ) vorgesehen ist, der eine unmittelbar oberhalb der Probe angeordnete, auf hohem positivem Potential ($V_E$) liegende ebene Absaugelektrode (G1) und die der Probe (PR) nächstliegende kugelsymmetrische Elektrode (K1) leitend miteinander verbindet.

5. Spektrometer-Objektiv nach einem der Ansprüche 1 bis 4, dadurch **gekennzeichnet,** daß eine elektrische Immersionslinse zum Absaugen und Beschleunigen der auf der Probe (PR) ausgelösten Sekundärelektronen (SE) vorgesehen ist.

6. Spektrometer-Objektiv nach einem der Ansprüche 1 bis 5, dadurch **gekennzeichnet,** daß mehrere Detektoren (DT) zum Nachweis der Sekundärelektronen (SE) oberhalb der kugelsymmetrischen Netzelektroden (K1, K2) symmetrisch zur optischen Achse (OA) angeordnet sind.

7. Spektrometer-Objektiv nach einem der Ansprüche 1 bis 6, dadurch **gekennzeichnet,** daß eine auf negativem Potential liegende Gitterelektrode (AE) zur Ablenkung der in Richtung der optischen Achse (OA) emittierten Sekundärelektronen (SE) oberhalb der kugelsymmetrischen Elektroden (K1, K2) vorgesehen ist.

## Claims

1. Spectrometer objective for quantitative measurements of potential in electron beam measuring techniques, in which an electron-optical unit is formed by a magnetic objective lens (OL) for focusing a primary electron beam (PE) onto a specimen (PR) and an electrostatic opposing field spectrometer which has an electrode arrangement (G1) for the extraction of the secondary electrons (SE) triggered on the specimen (PR) by the primary electron beam (PE) and an electrode arrangement (K1, K2) for generating an electrical opposing field which retards the secondary electrons (SE), a detector arrangement (DT) being coordinated with this spectrometer objective in order to detect the secondary electrons (SE), characterised in that a deflection system (DS) is provided within a magnetic objective lens (OL) of short focal length and is arranged symmetrically with respect to the optical axis (OA) between the electrode arrangement (G1) for extraction of the secondary electrons (SE) triggered on the specimen (PR) and the electrode arrangement (K1, K2) for generating the electrical opposing field which retards the secondary electrons (SE).

2. Spectrometer objective as claimed in claim 1., characterised by a single-stage deflection system (DS).

3. Spectrometer objective as claimed in claims 1 or 2, characterised in that
   - the electrode arrangement for generating an electrical opposing field has two spherically symmetrical electrodes (K1, K2) arranged immediately above the objective lens (OL), the potentials ($V_E$, $V_G$) of these electrodes being chosen so that a spherically symmetrical opposing field is built up in the space between these electrodes,
   - the centres of these spherically symmetrical electrodes (K1, K2) coincide at a point lying on the optical axis (OA) within the objective lens (OL),
   - this point lies in a spatial region which is free of electrical fields in the centre (M) of the deflection system (DS), and
   - the secondary electrons (SE) triggered on the specimen (PR) are focused in the field of the objective lens (OL) at a point (ZS) lying on the optical axis (OA) within the objective lens (OL).

4. Spectrometer objective as claimed in one of claims 1 to 3, characterised in that in order to generate a space within the objective lens (OL) which is free of electrical fields a hollow cylinder (HZ) is provided which is arranged concentrically with respect to the optical axis (OA) and which connects together conductively a planar extraction electrode (G1), which has a positive potential $(V_E)$ and is arranged immediately above the specimen, and the spherically symmetrical electrode (K1) which lies closest to the specimen (PR).

5. Spectrometer objective as claimed in one of claims 1 to 4, characterised in that an electrical immersion lens is provided for extraction and acceleration of the secondary electrons (SE) triggered on the specimen (PR).

6. Spectrometer objective as claimed in one of claims 1 to 5, characterised in that several detectors (DT) to detect the secondary electrons (SE) are arranged above the spherically symmetrical grid electrodes (K1, K2) symmetrically with respect to the optical axis (OA).

7. Spectrometer objective as claimed in one of claims 1 to 6, characterised in that a grid electrode (AE) having a negative potential is provided above the spherically symmetrical electrodes (K1, K2) to deflect the secondary electrons (SE) emitted in the direction of the optical axis (OA).

**Revendications**

1. Objectif à spectromètre pour mesures quantitatives de potentiel en technologie de mesure par faisceau d'électrons, dans lequel une lentille magnétique d'objectif (OL) destinée à focaliser un faisceau d'électrons primaires (PE) sur un échantillon (PR) et un spectromètre à champ életrostatique antagoniste, qui comprend un montage d'électrode (G1) d'attraction des électrons secondaires (SE) libérés du faisceau d'électrons primaires (PE) sur l'échantillon (PR) et un montage d'électrodes (K1, K2) destiné à crée un champ électrique antagoniste de freinage des électrons secondaires (SE), forment une unité opto-électronique, et qui est combiné avec un montage de détection (DT) destiné à l'identification des électrons secondaires (SE),
caractérisé en ce que,
un système de déviation (DS), prévu à l'intérieur d'une lentille magnétique de l'objectif (OL) à courte distance focale, est disposé symétriquement à l'axe optique (OA) entre le montage d'électrode (G1) d'attraction des électrons secondaires (SE) libérés sur l'échantillon (PR) et le montage d'électrodes (K1, K2) destiné à créer le champ électrique antagoniste de freinage des électrons secondaires (SE).

2. Objectif à spectromètre selon la revendication 1, caractérisé par un système de déviation à un étage (DS).

3. Objectif à spectromètre selon la revendication 1 ou 2, caractérisé en ce que :
   - le montage d'électrodes destiné à créer un champ électrique antagoniste comprend deux électrodes à symétrie sphérique (K1, K2) disposées immédiatement au-dessus de la lentille de l'objectif (OL) et dont les potentiels $(V_E, V_G)$ sont adoptés de manière que
   - il se crée un champ antagoniste à symétrie sphérique dans le volume compris entre ces électrodes,
   - les centres de ces électrodes à symétrie sphérique (K1, K2) coïncident en un point situé à l'intérieur de la lentille de l'objectif (OL) surl'axe optique (OA),
   - ce point est situé au milieu (M) du système de déviation (DS) dans un espace exempt de champs électriques, et
   - les électrons secondaires (SE) libérés sur l'échantillon (PR) sont focalisés dans le champ de la lentille de l'objectif (OL) en un point (ZS) situé sur l'axe optique (OA) à l'intérieur de la lentille de l'objectif (OL).

4. Objectif à spectromètre selon l'une des revendications 1 à 3, caractérisé en ce qu'un cylindre creux (HZ) prévu concentriquement à l'axe optique (OA) pour créer un volume exempt de champs électriques à l'intérieur de la lentille de l'objectif (OL) connecte une électrode plane d'attraction (G1), qui est disposée immédiatement au-dessus de l'échantillon et qui est à un potentiel positif élevé $(V_E)$, et l'électrode à symétrie sphérique (K1) qui est la plus proche de l'échantillon (PR).

5. Objectif à spectromètre selon l'une des revendications 1 à 4, caractérisé en ce qu'une lentille électrique à immersion d'attraction et d'accélération des électrons secondaires (SE) libérés sur l'échantillon (PR) est prévue.

6. Objectif à spectromètre selon l'une des revendications 1 à 5, caractérisé en ce que plusieurs détecteurs (DT) d'identification des électrons secondaires (SE) sont disposés symétriquement à l'axe optique (OA) au-dessus des électrodes réticulaires à symétrie sphérique (K1, K2).

7. Objectif à spectromètre selon l'une des revendications 1 à 6, caractérisé en ce qu'une électrode en grille (AE), qui est à un potentiel négatif, est prévue pour dévier les électrons secondaires (SE) émis vers l'axe optique (OA) au-dessus des électrodes à symétrie sphérique (K1, K2).

# FIG 1

## FIG 2

## FIG 3